## Europäisches Patentamt

## European Patent Office

## Office européen des brevets

(11) Veröffentlichungsnummer: **0 237 605**
**B1**

(12) **EUROPÄISCHE PATENTSCHRIFT**

(45) Veröffentlichungstag der Patentschrift:
**31.05.89**

(51) Int. Cl.⁴: **H03F 1/32**, H03F 3/45

(21) Anmeldenummer: **86103882.6**

(22) Anmeldetag: **21.03.86**

(54) Differenzverstärker mit N-Kanal-Isolierschicht-Feldeffekttransistoren.

(43) Veröffentlichungstag der Anmeldung:
**23.09.87 Patentblatt 87/39**

(45) Bekanntmachung des Hinweises auf die Patenterteilung:
**31.05.89 Patentblatt 89/22**

(84) Benannte Vertragsstaaten:
**DE FR NL**

(56) Entgegenhaltungen:
**EP-A- 0 121 688**
**GB-A- 2 150 380**
**US-A- 3 970 951**

**IEEE JOURNAL OF SOLID-STATE CIRCUITS, Band SC-19, Nr. 6, Dezember 1984, Seiten 932-938, IEEE, New York, US; J.N. BABANEZHAD et al.: "A linear NMOS depletion resistor and its application in an integrated amplifier"**

(73) Patentinhaber: **Deutsche ITT Industries GmbH,
Hans-Bunte-Strasse 19 Postfach 840,
D-7800 Freiburg(DE)**

(72) Erfinder: **O'Leary, Paul, Schwarzwaldstrasse 24,
D-7803 Gundelfingen(DE)**

## Beschreibung

Die Erfindung betrifft Differenzverstärker mit N-Kanal-Isolierschicht-Feldeffekttransistoren, bei denen das eine Ende der Source-Drain-Strecke jedes Verstärkertransistors vom Enhancement-Typ über je einen Lasttransistor vom Depletion-Typ, dessen Gate mit dessen Source verbunden ist, am spannungsführenden Pol einer Betriebsspannungsquelle und das andere Ende über eine gemeinsame Konstantstromschaltung mit mindestens einem Konstantstromtransistor vom Enhancement-Typ am Schaltungsnullpunkt liegt, vgl. den Oberbegriff des Patentanspruchs.

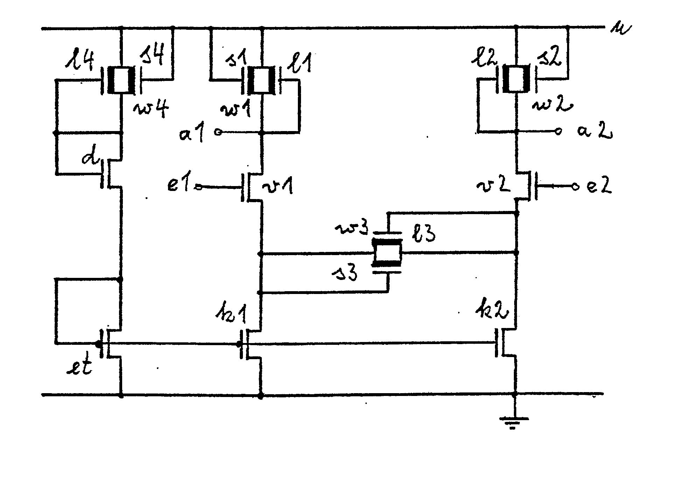

Ein derartiger Differenzverstärker ist in der vorveröffentlichten Patentanmeldung EP-A 0 139 078, insb. in Zusammenhang mit Fig. 1, beschrieben. Da als Arbeitswiderstand der Verstärkertransistoren Depletiontransistoren dienen, werden die Verzerrungen dieses Verstärkers von diesen Depletiontransistoren im wesentlichen bestimmt, und zwar auf zweifache Weise, nämlich zum einen durch die im wesentlichen quadratische Strom-Spannungskennlinie des Lasttransistors und andererseits durch die Abhängigkeit der Gate-Schwellspannung von der Source-Drain-Spannung. Bei der monolithischen Integrierung könnten anstatt der Deletiontransistoren Polysilizium-Widerstände vorgesehen werden, jedoch benötigen diese im allgemeinen zuviel Kristallfläche der integrierten Schaltung und unterliegen im übrigen auch starken Herstellprozeßschwankungen.

Die Aufgabe der im Patentanspruch umschriebenen Erfindung besteht somit darin, ausgehend von der vorbeschriebenen Schaltung, einen Differenzverstärker anzugeben, der auch bei Verstärkung von hochfrequenten Eingangssignalen eine möglichst kleine Verzerrung aufweist. Dies wird bei der Erfindung durch die Ergänzung der Depletion-Lasttransistoren zu an sich bekannten Depletionwiderständen sowie durch den im Sourcekreis der beiden Verstärkertransistoren angeordneten weiteren Depletionwiderstand erreicht, der jedoch anders hinsichtlich des Längen-Breiten-Verhältnisses des Kanals seiner Transistoren bemessen ist als die Arbeits-Depletionwiderstände.

Die erwähnten Depletionwiderstände sind in "IEEE J. Sol. St. Circ.", Dez. 1984, Seiten 932 bis 938 beschrieben. Zwar ist dort gezeigt, daß sie als äußere Zusatzbeschaltung im Rückkopplungszweig von Operationsverstärkern verwendet werden können, jedoch zeigen auch die Kristallfotos der Fig. 8 auf Seite 937 gerade nicht, daß die Autoren dieses Aufsatzes an die Verwendung dieser Depletionwiderstände als Arbeitswiderstände innerhalb des Operationsverstärkers und somit seiner Differenzverstärkerstufen gedacht haben.

Aus der Offenlegungsschrift DE-A 20 19 283 ist es bei mit bipolaren Transistoren realisierten Differenzverstärkern an sich bekannt, im Emitterkreis der Verstärkertransistoren für jeden von ihnen einen Konstantstromtransistor vorzusehen und die Emitter über ein Widerstandsnetzwerk miteinander zu verbinden.

Die Erfindung wird nun anhand der Figur der Zeichnung näher erläutert, die das Schaltbild eines Ausführungsbeispiels des Differenzverstärkers zeigt.

Wie bei Differenzverstärkern üblich und seit langem bekannt sind in Fig. 1 die Verstärkertransistoren v1, v2 vom Enhancement-Typ vorgesehen. Die Source-Drain- Strecke ist dabei jeweils über den Lasttransistor l1, l2 vom Depletion-Typ am spannungsführenden Pol u der Betriebsspannungsquelle und andererseits über die Source-Drain-Strecke des Konstantstromtransistors k1, k2 vom Enhancement-Typ am Schaltungsnullpunkt angeschlossen. Bei jedem Lasttransistor l1, l2 ist dessen Gate mit desssen Source verbunden, so daß sie als Konstantstromquellen wirken.

Ensprechend einem Merkmal der Erfindung sind die Lasttransistoren l1, l2 zu den Depletionwiderständen w1, w2 dadurch ergänzt, daß ihrer Source-Drain-Strecke die des Shunttransistors s1, s2 jeweils parallelgeschaltet ist, wobei dessen Gate jeweils mit dessen Drain verbunden ist und somit am spannungsführenden Pol u liegt.

Dem jeweiligen Gate der Verstärkertransistoren v1, v2 sind die Eingangssignale e1, e2 zugeführt, und am Verbindungspunkt von Verstärkertransistor und Depletionwiderstand sind die Ausgangssignale a1, a2 abzunehmen. Die bezüglich dieses Verbindungspunkts anderen Enden der Source-Drain-Strecke der Verstärkertransistoren v1, v2 sind über den dritten Depletionwiderstand w3 miteinander verbunden. Dabei besteht dieser Widerstand wiederum aus zwei mit ihren Source-Drain-Strecken parallelgeschalteten Depletiontransistoren l3, s3, die die Source des Verstärkertransistors v1 mit der des Verstärkertransistors v2 verbinden. Dabei liegt das Gate des Transistors l3 an der Source des Verstärkertransistors v2 und das des Transistors s3 an der des Verstärkertransistors v1.

Die Konstantstromtransistoren k1, k2 sind in eine Konstantstromschaltung dadurch einbezogen, daß ihre Gates am Gate des strombestimmenden Eingangstransistors et der Konstantstromschaltung liegen, der ebenfalls vom Enhancement-Typ ist. Dessen Gate ist mit dessen Drain verbunden, und dessen Source-Drain-Strecke liegt einerseits am Schaltungsnullpunkt und andererseits in dieser Reihenfolge über den als Diode geschalteten Enhancementtransistor d und den vierten Depletionwiderstand w4 am spannungsführenden Pol u.

Auch der vierte Depletionwiderstand w4 besteht aus den mit ihren Source-Drain-Strecken parallelgeschalteten Transistoren l4, s4, wobei das Gate des letzteren am spannungsführenden Pol u und das des ersteren am Verbindungspunkt von Transistor d und Widerstand w4 angeschlossen ist. Der letztere Transistor weist ebenfalls eine Gate-Drain-Verbindung auf.

Die beabsichtigte große Verzerrungsfreiheit ergibt sich bei der Erfindung ferner durch die Dimensionierung des jeweiligen Längen-Breiten-Verhältnisses, also des W/L-Verhältnisses, der vier Depletionwiderstände. So haben die Transistoren l3, s3 des dritten Depletiontransistors w3 im gemeinsamen Source-Kreis der Verstärkertransistoren v1, v2 dasselbe W/L-Verhältnis. Diese Dimensionierung weicht von der in der genannten Literaturstelle auf Seite 933 angegebenen Dimensionierung für die vorgeschriebenen Depletionwiderstände gerade ab.

Andererseits sind bei der Erfindung die übrigen Depletionwiderstände w1, w2, w4 so dimensioniert, daß das W/L-Verhältnis ihrer jeweiligen Transistoren s1, l1; s2, l2; s4, l4 untereinander verschieden ist, wobei dies pro Widerstand individuell eingestellt werden kann.

Bei einer realisierten Schaltung wurde für hochfrequente Eingangssignale ein Gesamtklirrfaktor von 0,2% gemessen. Dabei ist der Verstärkungsfaktor von der Schwellspannung der Depletiontransistoren unabhängig.

## Patentansprüche

1. Differenzverstärker mit N-Kanal-Isolierschicht-Feldeffekttransistoren, bei dem das eine Ende der Source-Drain-Strecke jedes Verstärkertransistors (v1,v2) vom Enhancement-Typ über je einen Lasttransistor (l1, l2) vom Depletion-Typ, dessen Gate mit dessen Source verbunden ist, am spannungsführenden Pol (u) einer Betriebsspannungsquelle und das andere Ende über eine gemeinsame Konstantstromschaltung mit mindestens einem Konstantstromtransistor vom Enhancement-Typ am Schaltungsnullpunkt liegt, gekennzeichnet durch folgende Merkmale:

- der Source-Drain-Strecke jedes Lasttransistors (l1, l2) ist die eines Shunt-Transistors (s1, s2), dessen Gate mit dessen Drain verbunden ist, zur Bildung eines ersten bzw. eines zweiten Depletionwiderstands (w1, w2) parallelgeschaltet,
- das andere Ende der Source-Drain-Strecke jedes Verstärkertransistors (v1, v2) liegt über die je eines Konstantstromtransistors (k1, k2) am Schaltungsnullpunkt,
- die anderen Enden der jeweiligen Source-Drain-Strecke der Verstärkertransistoren (v1, v2) sind über einen dritten, wie der erste (w1) und zweite (w2) Depletionwiderstand gebildeten Depletionwiderstand (w3) miteinander verbunden,
- die Gates der Konstantstromtransistoren (k1, k2) liegen an Gate und Source des Eingangstransistors (et) der Konstantstromschaltung, der vom Enhancement-Typ ist und dessen Source-Drain-Strecke einerseits am Schaltungsnullpunkt und andererseits in dieser Reihenfolge über einen als Diode geschalteten Enhancementtransistor (d) und einen vierten, wie der erste (w1) und zweite (w2) Depletionwiderstand gebildeten Depletionwiderstand (w4) am spannungsführenden Pol (u) liegt,
- daß Längen-Breiten-Verhältnis des Kanals des Lasttransistors (l3) des dritten Depletionwiderstands (w3) ist gleich dem des zugehörigen Shunt-Transistors (s3), und
- das Längen-Breiten-Verhältnis des Kanals des jeweiligen Lasttransistors (l1, l2, l4) des ersten, zweiten und vierten Depletionwiderstands (w1, w2, w4) ist jeweils verschieden von dem des zugehörigen Shunt-Transistors (s1, s2, s4).

## Claims

1. Differential amplifier using N-channel insulated-gate field-effect transistors wherein one end of the source-drain path of each enhancement-mode amplifying transistor (v1, v2) is connected to the live terminal (u) of a supply-voltage source via a load transistor (l1, l2) having its gate connected to its source, and wherein the other end of said source-drain path is grounded through a common constant-current circuit containing at least one enhancement-mode constant-current transistor, characterized by the following features:

- The source-drain path of a shunt transistor (s1, s2) having its gate connected to its drain is connected in parallel with the source-drain path of each load transistor (l1, l2) to form a first depletion resistor (w1) and a secon depletion resistor (w2), respectively,
- the other end of the source-drain path of each amplifying transistor (v1, v2) is grounded through the source-drain path of a constant-current transistor (k1, k2);
- the other ends of the source-drain paths of the amplifying transistors (v1, v2) are interconnected via a third depletion resistor (w3), which is formed like the first (w1) and second (w2) depletion resistors;
- the gates of the constant-current transistors (k1, k2) are connected to the gate and source of the input transistor (et) of the constant-current circuit, which is an enhancement-mode transistor and whose source-drain path has one end grounded and the other end connected via a diode-connected enhancement-mode transistor (d) and a fourth depletion resistor (w4), which is formed like the first (w1) and second (w2) depletion resistors, to the live terminal (u);
- the length-to-width ratio of the channel of the load transistor (l3) of the third depletion resistor (w3) is equal to that of the associated shunt transistor (s3), and
- the length-to-width ratios of the channels of the load transistors (l1, l2, l4) of the first, second, and fourth depletion resistors (w1, w2, w4) are different from those of the associated shunt transistors (s1, s2, s4).

## Revendications

1. Amplificateur différentiel comportant des transistors à effet de champ à grille isolée à canal N, dans lequel une extrémité de la voie source-drain de chaque transistor (v1, v2) de l'amplificateur, du type à enrichissement, est raccordée, par l'intermédiaire d'un transistor respectif de charge (11, 12) du type à appauvrissement, dont la grille est reliée à la source de ce transistor, au pôle sous tension (u) d'une source de tension de service, et l'autre extrémité est reliée au point neutre du circuit par l'intermédiaire d'un circuit commun délivrant un courant constant, comportant au moins un transistor à courant constant, du type à enrichissement, caractérisé par les caractéristiques suivantes:

– la voie source-drain d'un transistor shunt (s1, s2), dont la grille est reliée au drain de ce transistor, est branchée en parallèle avec la voie source-drain de chaque transistor de charge (11, 12), de manière à former une première et une seconde résistances à appauvrissement (w1, w2),

– l'autre extrémité de la voie source-drain de chaque transistor (v1, v2) de l'amplificateur est raccordée au point neutre du circuit par l'intermédiaire de transistors à courant constant respectifs (k1, k2),

– les autres extrémités des voies respectives source-drain des transistors (v1, v2) de l'amplificateur sont reliées entre elles par l'intermédiaire d'une troisième résistance à appauvrissement (w3) formée comme la première résistance à appauvrissement (w1) et comme la seconde résistance à appauvrissement (w2),

– les grilles des transistors à courant constant (k1, k2) sont raccordées à la grille et à la source du transistor d'entrée (et) du circuit délivrant un courant constant, qui est du type à enrichissement et dont la voie source-drain est raccordée d'une part au point neutre du circuit et d'autre part au pôle sous tension (u) par l'intermédiaire, dans cet ordre, d'un transistor à enrichissement (d) branché en tant que diode et d'une quatrième résistance à appauvrissement (w4) formée comme la première résistance à appauvrissement (w1) et comme la seconde résistance à appauvrissement (w2),

– le rapport longueur/largeur du canal du transistor de charge (13) de la troisième résistance à appauvrissement (w3) est égal à celui du transistor shunt (s3) associé, et

– le rapport longueur/largeur du canal du transistor respectif de charge (11, 12, 14) des première, seconde et quatrième résistances à appauvrissement (w1, w2, w4) diffère respectivement de celui du transistor shunt associé (s1, s2, s4).